# EUROPEAN PATENT SPECIFICATION

(11) **EP 3 648 343 B1**
(45) Date of publication and mention of the grant of the patent: **07.09.2022**
(21) Application number: 17919295.0
(22) Date of filing: 27.07.2017
(51) Int. Cl.: H01P 1/18, H03F 1/02, H03F 3/21, H03F 3/60

(54) **DOHERTY AMPLIFIER AND AMPLIFICATION CIRCUIT**
DOHERTY-VERSTÄRKER UND VERSTÄRKUNGSSCHALTUNG
AMPLIFICATEUR DOHERTY ET CIRCUIT D'AMPLIFICATION

(43) Date of publication of application: 06.05.2020
(73) Proprietor: Mitsubishi Electric Corporation, Chiyoda-ku Tokyo 100-8310 (JP)
(72) Inventor: NAKATANI, Keigo, Tokyo 100-8310 (JP); SAKATA, Shuichi, Tokyo 100-8310 (JP); SHINJO, Shintaro, Tokyo 100-8310 (JP); YAMANAKA, Koji, Tokyo 100-8310 (JP)
(74) Representative: Pfenning, Meinig & Partner mbB
(86) International application number: PCT/JP2017/027277
(87) International publication number: WO 2019/021426

(56) References cited:
- EP-A1- 2 658 116
- EP-A1- 2 775 609
- WO-A1-2004/017512
- WO-A1-2009/072944
- JP-A- 2006 067 176
- JP-A- 2006 191 581
- JP-A- 2006 333 022
- JP-A- 2017 005 478
- JP-U- S4 972 139
- US-A1- 2006 139 091
- US-A1- 2007 008 032
- US-A1- 2012 235 734
- "A new structure to realize flexible switch between Dual TX transmission and digital Doherty power amplifier", RESEARCH DISCLOSURE, KENNETH MASON PUBLICATIONS, HAMPSHIRE, UK, GB, vol. 562, no. 15, 1 February 2011 (2011-02-01), pages 191-193, XP007140280, ISSN: 0374-4353

## Description

### TECHNICAL FIELD

The present invention relates to a Doherty amplifier and an amplification circuit for amplifying a signal to be amplified.

### BACKGROUND ART

In amplification elements such as field effect transistors (FETs), high power efficiency is achieved, but the linearity of input/output characteristics is deteriorated at the time of large signal operation in which the operation is carried out near a saturation region.

On the other hand, amplification elements have a disadvantage that the power efficiency is deteriorated while the linearity of input/output characteristics is improved at the time of small signal operation in which the operation is carried out in a power region lower than the saturation region. As amplifiers that solve these disadvantage, Doherty amplifiers are known.

A Doherty amplifier disclosed in Patent Literature 1 listed below includes the following components (1) to (7):
(1) A distributor for dividing a signal to be amplified into two signals;
(2) A carrier amplifier for amplifying one of the signals distributed by the distributor;
(3) A first transmission line, one end of which being connected to an output side of the carrier amplifier;
(4) A phase shifter for delaying the phase of the other signal distributed by the distributor by 90 degrees;
(5) A peak amplifier for amplifying the signal the phase of which being delayed by the phase shifter;
(6) A second transmission line, one end of which being connected to an output side of the peak amplifier; and
(7) A synthesizer, a first input terminal of which being connected to the other end of the first transmission line, and a second input terminal of which being connected to the other end of the second transmission line.

EP 2 658 116 A1 relates to an amplifier circuit, comprising a digital baseband processor operable to decompose a digital baseband signal having a useful signal bandwidth into a first signal part and into a second signal part, a first amplifier operable to amplify a first radio frequency signal corresponding to the first signal part, a second amplifier operable to amplify a second radio frequency signal corresponding to the second signal part, wherein the first and the second amplifiers are coupled to each other by means of at least one quarter-wavelength transformer having a non-constant phase transfer function over the useful signal bandwidth, and wherein the digital baseband processor is operable to process the second and/or the first signal part for at least partially pre-compensating the non-constant phase transfer function.

US 2012/235734 A1 relates to an enhanced Doherty amplifier that provides significant performance improvements over conventional Doherty amplifiers. The enhanced Doherty amplifier includes a power splitter, combining node, a carrier path, and a peaking path. The power splitter is configured to receive an input signal and split the input signal into a carrier signal provided at a carrier splitter output and a peaking signal provided at a peaking splitter output. The carrier path includes carrier power amplifier circuitry, a carrier input network coupled between the carrier splitter output and the carrier power amplifier circuitry, and a carrier output network coupled between the carrier power amplifier circuitry and the Doherty combining node. The peaking path includes peaking power amplifier circuitry, a peaking input network coupled between the peaking splitter output and the peaking power amplifier circuitry, and a carrier output network coupled between the power amplifier circuitry and the Doherty combining node.

US 2006/139091 A1 relates to an amplifier includes a signal splitter operable to receive an input signal and generate at least first and second split signals, a first amplifier adapted to receive the first split signal and to generate a first amplified signal, and a second amplifier adapted to receive the second split signal and to generate a second amplified signal. A combining circuit is adapted to generate an output signal which is a sum of the first amplified signal and the second amplified signal. The amplifier further includes a phase control circuit arranged in a signal path of one of the first and second amplifiers, the phase control circuit comprising at least one thin film ferroelectric element. The amount of phase shift provided by the phase control circuit is selectively variable as a function of a control signal applied thereto.

WO 2009/072944 A1 concerns a load modulation arrangement adapted to be connected to an amplifying device. The load modulation arrangement comprises a first reactive element, a second reactive element and at least one variable capacitive element. Further, the load modulation arrangement comprises a quarter wave transforming element adapted to be connected to the first reactive element. The present invention also concerns a method for load modulation, a wireless transceiver and a radio transmission device.

### CITATION LIST

### PATENT LITERATURES

Patent Literature 1: JP 2006-332829 A

### SUMMARY OF INVENTION

### TECHNICAL PROBLEM

Doherty amplifiers are capable of implementing high linearity of input/output characteristics and high power efficiency by causing both a carrier amplifier and a peak amplifier to operate in a saturation region of the carrier amplifier and causing only the carrier amplifier to operate in a power region lower than the saturation region (hereinafter referred to as back-off operation).

However, in the Doherty amplifier disclosed in Patent Literature 1, a signal distributed by the distributor is always provided to the peak amplifier regardless of the power of the signal to be amplified. Therefore, there is a disadvantage that unnecessary power consumption occurs at the time of back-off operation since the peak amplifier operates even in the back-off operation.

Further, the first transmission line is connected to the output side of the carrier amplifier, and the second transmission line is connected to the output side of the peak amplifier, and thus the output impedance of the carrier amplifier and the output impedance of the peak amplifier are matched. However, when the frequency of a signal to be amplified changes from a desired frequency, a mismatch occurs between the output impedance of the carrier amplifier and the output impedance of the peak amplifier. Therefore, there is a disadvantage that the power efficiency is deteriorated when the frequency of a signal to be amplified changes from a desired frequency.

The present invention has been made to solve the above-described disadvantages, and it is an object of the present invention to provide a Doherty amplifier and an amplification circuit capable of suppressing unnecessary power consumption at the time of back-off operation and suppressing deterioration of power efficiency even when a frequency of a signal to be amplified changes.

### SOLUTION TO PROBLEM

A Doherty amplifier according to the present invention is set out in the appended set of claims.

### ADVANTAGEOUS EFFECTS OF INVENTION

According to the present invention, in a case where a power of the signal to be amplified is greater than or equal to a threshold value, the signal distributor outputs the one of the signals to the carrier amplifier, outputs said another one of the signals, a phase of which is 90 degrees behind the phase of the one of the signals, to the peak amplifier, and adjusts a phase shift amount of a signal shifted by the phase shifter depending on a frequency of the signal to be amplified. In a case where the power of the signal to be amplified is less than the threshold value, the signal distributor outputs the one of the signals to the carrier amplifier without outputting another one of the signals to the peak amplifier. Therefore, there are effects of suppressing unnecessary power consumption at the time of back-off operation and suppressing deterioration of power efficiency even when a frequency of a signal to be amplified changes.

### BRIEF DESCRIPTION OF DRAWINGS

FIG. 1 is a configuration diagram illustrating a Doherty amplifier according to a first embodiment of the present invention.
FIG. 2 is a configuration diagram illustrating a phase shifter 7 of the Doherty amplifier according to the first embodiment of the present invention.
FIG. 3 is an explanatory graph illustrating the relationship of power between a first analog signal A₁ which is an input signal of a carrier amplifier 6 and a second analog signal A₂ which is an input signal of a peak amplifier 8.
FIG. 4 is an explanatory graph illustrating the power efficiency with respect to the output power of the Doherty amplifier of the first embodiment and the power efficiency with respect to the output power of a Doherty amplifier disclosed in Patent Literature 1.
FIG. 5 is an explanatory graph illustrating simulation results of the frequency characteristics of power efficiency in back-off operation in the Doherty amplifier of the first embodiment and the frequency characteristics of power efficiency in back-off operation in the Doherty amplifier disclosed in Patent Literature 1.
FIG. 6 is a configuration diagram illustrating a phase shifter 7 of a Doherty amplifier not part of the present invention and being shown for illustration purpose only.
FIG. 7 is a configuration diagram illustrating a phase shifter 7 of a Doherty amplifier according to a third embodiment of the present invention.
FIG. 8 is a configuration diagram illustrating a Doherty amplifier according to a fourth embodiment of the present invention.
FIG. 9 is a configuration diagram illustrating an amplification circuit according to a fifth embodiment of the present invention.

### DESCRIPTION OF EMBODIMENTS

To describe the present invention further in detail, some embodiments for carrying out the present invention will be described below with reference to the accompanying drawings.

### First Embodiment

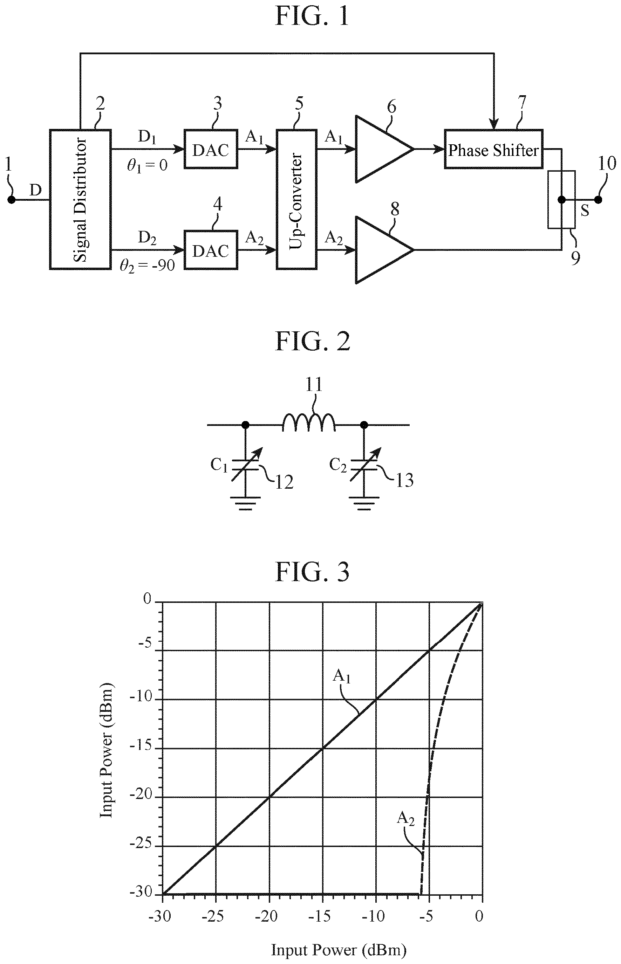

FIG. 1 is a configuration diagram illustrating a Doherty amplifier according to a first embodiment of the invention.

In FIG. 1, an input terminal 1 receives input of a signal to be amplified.

In the first embodiment, an example in which a signal to be amplified is a digital signal will be described; however in a case where a signal to be amplified is an analog signal, digital/analog converters 3 and 4 are unnecessary.

In FIG. 1, the digital/analog converters 3 and 4 are each denoted as "DAC."

A signal distributor 2 distributes a digital signal D input from the input terminal 1 and is implemented by, for example, a digital signal processor (DSP).

Specifically, the signal distributor 2 compares a power P of the digital signal D input from the input terminal 1 with a threshold value Pₜₕ set in advance.

The signal distributor 2 outputs a first digital signal D₁ which is one of the distributed digital signals to the digital/analog converter 3 and outputs a second digital signal D₂ which is the other distributed digital signal to the digital/analog converter 4 in a case where the power P of the digital signal D input from the input terminal 1 is greater than or equal to the threshold value Pₜₕ. At this time, the signal distributor 2 sets the phase of the first digital signal D₁ to θ₁ = 0° and the phase of the second digital signal D₂ to θ₂ = -90°.

Furthermore, the signal distributor 2 adjusts the phase shift amount of a signal in a phase shifter 7 depending on a frequency f of the digital signal D so that the phase delays by 90° by the phase shifter 7.

In a case where the power P of the digital signal D input from the input terminal 1 is less than the threshold value Pₜₕ, the signal distributor 2 outputs the first digital signal D₁ to the digital/analog converter 3 without outputting the second digital signal D₂ to the digital/analog converter 4.

The digital/analog converter 3 converts the first digital signal D₁ output from the signal distributor 2 to the first analog signal A₁ and outputs the first analog signal A₁ to an up-converter 5.

The digital/analog converter 4 converts the second digital signal D₂ output from the signal distributor 2 into a second analog signal A₂ and outputs the second analog signal A₂ to the up-converter 5.

The up-converter 5 performs frequency conversion to increase the frequency of the first analog signal A₁ output from the digital/analog converter 3, and outputs the first analog signal A₁ after the frequency conversion to a carrier amplifier 6.

The up-converter 5 performs frequency conversion to increase the frequency of the second analog signal A₂ output from the digital/analog converter 4, and outputs the second analog signal A₂ after the frequency conversion to a peak amplifier 8.

The carrier amplifier 6 is implemented by, for example, an amplification element operating in class AB.

The carrier amplifier 6 amplifies the first analog signal A₁ output from the up-converter 5 and outputs the amplified first analog signal A₁ to the phase shifter 7.

The phase shifter 7 adjusts the phase of the amplified first analog signal A₁ output from the carrier amplifier 6 and outputs the phase-adjusted first analog signal A₁ to a signal synthesizer 9.

The peak amplifier 8 is implemented by, for example, an amplification element operating in class A or C.

The peak amplifier 8 amplifies the second analog signal A₂ output from the up-converter 5 and outputs the amplified second analog signal A₂ to the signal synthesizer 9.

The signal synthesizer 9 is connected to an output side of the phase shifter 7 at one of input sides thereof and is connected to an output side of the peak amplifier 8 at the other input side thereof.

The signal synthesizer 9 synthesizes the phase-adjusted first analog signal A₁ output from the phase shifter 7 and the amplified second analog signal A₂ output from the peak amplifier 8 and outputs a synthesized signal S of the first analog signal A₁ and the second analog signal A₂ to an output terminal 10.

The synthesized signal S is output from the output terminal 10.

FIG. 2 is a configuration diagram illustrating a phase shifter 7 of the Doherty amplifier according to a first embodiment of the present invention.

In FIG. 2, an inductive element 11 is an inductor having one end connected to an output side of the carrier amplifier 6 and the other end connected to one input side of the signal synthesizer 9.

A first variable capacitance element 12 is a variable capacitor having one end connected to the output side of the carrier amplifier 6 and the other end grounded, and having a capacitance value C₁ adjusted by the signal distributor 2.

A second variable capacitance element 13 is a variable capacitor having one end connected to one input side of the signal synthesizer 9 and the other end grounded, and having a capacitance value C2 adjusted by the signal distributor 2.

Next, an operation will be described.

When a digital signal D is input from the input terminal 1, the signal distributor 2 divides the digital signal D into two signals.

In this example, for convenience of explanation, one of the distributed digital signals is referred to as a first digital signal D₁, and the other distributed digital signal is referred to as a second digital signal D₂.

The signal distributor 2 compares a power P of the digital signal D with a threshold value Pₜₕ set in advance.

The threshold value Pₜₕ is set to a power such as a power at which the carrier amplifier 6 saturates or a power several percent smaller than the power at which the carrier amplifier 6 saturates.

In a case where the power P of the digital signal D is greater than or equal to the threshold value Pₜₕ, the signal distributor 2 outputs the first digital signal D₁ to the digital/analog converter 3 and outputs the second digital signal D₂ to the digital/analog converter 4.

At this time, the signal distributor 2 sets the phase of the first digital signal D₁ to θ₁ = 0° and the phase of the second digital signal D₂ to θ₂ = -90°.

In this example, the phase of the first digital signal D₁ is set to θ₁ = 0°, and the phase of the second digital signal D₂ is set to θ₂ = -90°; however, it is only required that the relation θ₁ - θ₂ = 90° holds, and thus, for example, they may be set such that θ₁ = 20° and θ₂ = -110°.

Furthermore, the signal distributor 2 adjusts the phase shift amount of a signal in the phase shifter 7 depending on a frequency f of the digital signal D so that the phase delays by 90° by the phase shifter 7.

Hereinafter, a method for adjusting the phase shift amount by the phase shifter 7 will be specifically described.

The signal distributor 2 stores a table indicating the relationship between the frequency f of the digital signal D, the capacitance value C₁ of the first variable capacitance element 12 in the phase shifter 7 and the capacitance value C2 of the second variable capacitance element 13 in the phase shifter 7.

The signal distributor 2 refers to the table to obtain the capacitance value C₁ and the capacitance value C2 each corresponding to the frequency f of the digital signal D.

The signal distributor 2 adjusts the first variable capacitance element 12 so that the capacitance value of the first variable capacitance element 12 becomes the acquired value C₁.

The signal distributor 2 adjusts the second variable capacitance element 13 so that the capacitance value of the second variable capacitance element 13 becomes the acquired value C2.

For example, if the frequency f of the digital signal D is higher than a reference frequency fo, the signal distributor 2 adjusts the first variable capacitance element 12 so that the capacitance value C₁ of the first variable capacitance element 12 becomes smaller than a reference capacitance value C_{1,0}. Further, the signal distributor 2 adjusts the second variable capacitance element 13 so that the capacitance value C2 of the second variable capacitance element 13 becomes smaller than a reference capacitance value C_{2,0}.

If the frequency f of the digital signal D is lower than a reference frequency fo, the signal distributor 2 adjusts the first variable capacitance element 12 so that the capacitance value C₁ of the first variable capacitance element 12 becomes larger than the reference capacitance value C_{1,0}. Further, the signal distributor 2 adjusts the second variable capacitance element 13 so that the capacitance value C2 of the second variable capacitance element 13 becomes larger than the reference capacitance value C_{2,0}.

If the frequency f of the digital signal D matches the reference frequency f₀, the signal distributor 2 does not adjust the first variable capacitance element 12 nor the second variable capacitance element 13.

As a result, even if the frequency f of the digital signal D changes, it is possible to set the phase shift amount of the signal by the phase shifter 7 to 90°. Therefore, if the phase of the first digital signal D₁ is set to θ₁ = 0°, the phase of the output signal of the phase shifter 7 becomes -90°.

In a case where the power P of the digital signal D input from the input terminal 1 is less than the threshold value Pₜₕ, the signal distributor 2 outputs the first digital signal D₁ to the digital/analog converter 3 without outputting the second digital signal D₂ to the digital/analog converter 4.

Furthermore, the signal distributor 2 adjusts the phase shift amount of a signal by the phase shifter 7 depending on the frequency f of the digital signal D so that the phase is delayed by 90° by the phase shifter 7 as in the case where the power P of the digital signal D is greater than or equal to the threshold value Pₜₕ.

Here, the signal distributor 2 adjusts the phase shift amount of a signal by the phase shifter 7 also in a case where the power P of the digital signal D is less than the threshold value Pₜₕ. However, since the second digital signal D₂ is not output to the digital/analog converter 4, the signal synthesizer 9 outputs the first analog signal A₁ as a synthesized signal S without synthesizing the first analog signal A₁ and the second analog signal A₂. Therefore, the signal distributor 2 may be configured not to adjust the phase shift amount of a signal by the phase shifter 7.

The digital/analog converter 3 converts the first digital signal D₁ output from the signal distributor 2 to the first analog signal A₁ and outputs the first analog signal A₁ to an up-converter 5.

In a case where the second digital signal D₂ is output from the signal distributor 2, the digital/analog converter 4 converts the second digital signal D₂ into a second analog signal A₂ and outputs the second analog signal A₂ to the up-converter 5.

The up-converter 5 performs frequency conversion to increase the frequency of the first analog signal A₁ output from the digital/analog converter 3, and outputs the first analog signal A₁ after the frequency conversion to a carrier amplifier 6.

In a case where the second analog signal A₂ is output from the digital/analog converter 4, the up-converter 5 performs frequency conversion to increase the frequency of the second analog signal A₂, and outputs the second analog signal A₂ after the frequency conversion to the peak amplifier 8.

The carrier amplifier 6 amplifies the first analog signal A₁ output from the up-converter 5 and outputs the amplified first analog signal A₁ to the phase shifter 7.

Since the first analog signal A₁ is output from the up-converter 5 regardless of whether the power P of the digital signal D is greater than or equal to the threshold value Pₜₕ, the carrier amplifier 6 always amplifies the first analog signal A₁.

The peak amplifier 8 amplifies the second analog signal A₂ output from the up-converter 5 and outputs the amplified second analog signal A₂ to the signal synthesizer 9.

The second analog signal A₂ is output from the up-converter 5 only in the case where the power P of the digital signal D is greater than or equal to the threshold value Pₜₕ. Therefore, the peak amplifier 8 amplifies the second analog signal A₂ in the saturation region of the carrier amplifier 6, but does not amplify the second analog signal A₂ in a power region lower than the saturation region of the carrier amplifier 6.

Therefore, back-off operation in which only the carrier amplifier 6 operates is performed in a power region lower than the saturation region.

The phase shifter 7 adjusts the phase of the amplified first analog signal A₁ output from the carrier amplifier 6 and outputs the phase-adjusted first analog signal A ₁ to a signal synthesizer 9.

Since the phase shift amount of a signal by the phase shifter 7 is adjusted by the signal distributor 2 depending on the frequency f of the digital signal D, even when the frequency f of the digital signal D changes, the phase of the first analog signal A₁ after the phase adjustment by the phase shifter 7 becomes -90°.

In the saturation region of the carrier amplifier 6, the signal synthesizer 9 synthesizes the phase-adjusted first analog signal A₁ output from the phase shifter 7 and the amplified second analog signal A₂ output from the peak amplifier 8 and outputs a synthesized signal S of the first analog signal A₁ and the second analog signal A₂ to the output terminal 10.

The phase of the phase-adjusted first analog signal A₁ output from the phase shifter 7 is -90°, and the phase of the amplified second analog signal A₂ output from the peak amplifier 8 is -90°, and thus in the signal synthesizer 9, the first analog signal A₁ and the second analog signal A₂ are in-phase synthesized.

In a power region lower than the saturation region, the back-off operation, in which only the carrier amplifier 6 operates, is performed, and the amplified second analog signal A₂ is not output from the peak amplifier 8. Therefore, the signal synthesizer 9 outputs the phase-adjusted first analog signal A₁ output from the phase shifter 7 to the output terminal 10 as a synthesized signal S.

In the back-off operation, since the second analog signal A₂ is not input to the peak amplifier 8, unnecessary power consumption in the peak amplifier 8 can be suppressed.

FIG. 3 is an explanatory graph illustrating the relationship of power between the first analog signal A₁ which is an input signal of the carrier amplifier 6 and the second analog signal A₂ which is an input signal of the peak amplifier 8.

In the example of FIG. 3, -6 to 0 (dBm) is the saturation region of the carrier amplifier 6.

In the example of FIG. 3, it is illustrated that the first analog signal A₁ is linearly input to the carrier amplifier 6, whereas the second analog signal A₂ is input to the peak amplifier 8 only when the carrier amplifier 6 is in the saturation region.

In the example of FIG. 3, the threshold value Pₜₕ in the signal distributor 2 is set to -6 (dBm), for example.

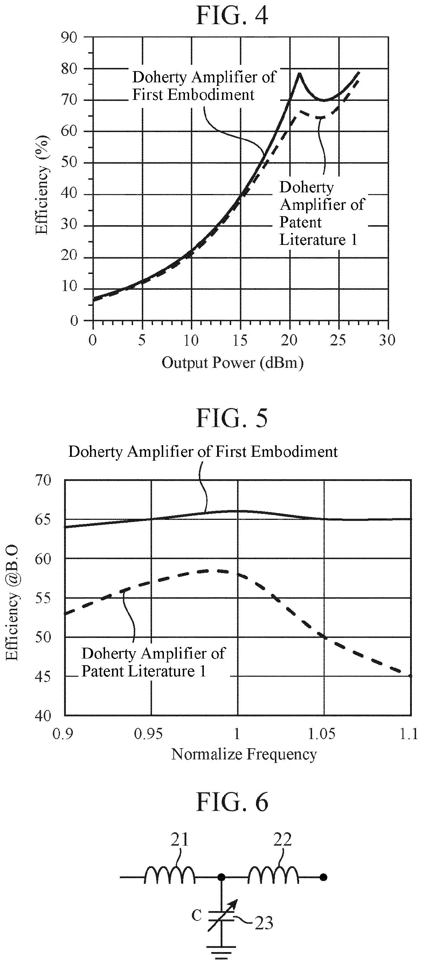

FIG. 4 is an explanatory graph illustrating the power efficiency with respect to the output power of the Doherty amplifier of the first embodiment and the power efficiency with respect to the output power of the Doherty amplifier disclosed in Patent Literature 1.

It can be seen from FIG. 4 that, in both Doherty amplifiers, the carrier amplifiers 6 and the peak amplifiers 8 operate in parallel in the saturation region of the carrier amplifier 6, thereby improving the power efficiency.

For example, when the output power in the saturation region of the carrier amplifier 6 is 27 (dBm), both Doherty amplifiers have high power efficiencies close to 80 (%).

In the Doherty amplifier disclosed in Patent Literature 1, a signal to be amplified is provided to the peak amplifier even in the back-off operation. This causes the peak amplifier to operate, and thus the power efficiency is lower than that of the Doherty amplifier of the first embodiment.

FIG. 5 is an explanatory graph illustrating simulation results of the frequency characteristics of power efficiency in back-off operation in the Doherty amplifier of the first embodiment and the frequency characteristics of power efficiency in back-off operation in the Doherty amplifier disclosed in Patent Literature 1.

In FIG. 5, the horizontal axis represents the normalized frequency, and the vertical axis represents the power efficiency during the back-off operation.

In the Doherty amplifier disclosed in Patent Literature 1, a first transmission line is connected to the output side of a carrier amplifier, and a second transmission line is connected to the output side of a peak amplifier, and thus the output impedance of the carrier amplifier and the output impedance of the peak amplifier are matched. However, when the frequency of a signal to be amplified changes from a desired frequency, a mismatch occurs between the output impedance of the carrier amplifier and the output impedance of the peak amplifier.

For this reason, as illustrated in FIG. 5, the power efficiency of the Doherty amplifier disclosed in Patent Literature 1 decreases as the fractional bandwidth of the frequency increases.

In the Doherty amplifier according to the first embodiment, the signal distributor 2 adjusts the phase shift amount of a signal by the phase shifter 7 depending on the frequency f of the digital signal D, and thus the power efficiency stays high as compared with the Doherty amplifier disclosed in Patent Literature 1 even when the fractional bandwidth of the frequency increases.

As apparent from the above, according to the first embodiment, in a case where a power of a signal to be amplified is greater than or equal to a threshold value, the signal distributor 2 outputs one of signals to the carrier amplifier 6, outputs the other signal, the phase of which is 90 degrees behind that of the one of the signals, to the peak amplifier 8, and adjusts a phase shift amount of a signal by the phase shifter 7 depending on a frequency of the signal to be amplified, and in a case where the power of the signal to be amplified is less than the threshold value, the signal distributor 2 outputs the one of the signals to the carrier amplifier 6 without outputting the other signal to the peak amplifier 8. As a result, it is possible to suppress unnecessary power consumption at the time of back-off operation and to suppress deterioration of power efficiency even when a frequency of a signal to be amplified changes.

The first embodiment illustrates the example in which the carrier amplifier 6 is implemented by an amplification element operating in class AB, and the peak amplifier 8 is implemented by an amplification element operating in class A or C.

For the amplification element to implement the carrier amplifier 6 or the peak amplifier 8, any semiconductor element having an amplification function can be used. For example, a silicon (Si)-lateral double diffused MOS (LDMOS), a FET, a high electron mobility transistor (HEMT), or a hetero junction bipolar transistor (HBT) can be used.

Further, each of the carrier amplifier 6 and the peak amplifier 8 may include a parasitic component and a matching circuit.

### Second Embodiment

In the first embodiment, an example in which the phase shifter 7 includes the inductive element 11, the first variable capacitance element 12, and the second variable capacitance element 13 is illustrated.

In a second embodiment, an example in which a phase shifter 7 includes a first inductive element 21, a second inductive element 22, and a variable capacitance element 23 will be described.

FIG. 6 is a configuration diagram illustrating the phase shifter 7 of a Doherty amplifier not part of the present invention and being shown for illustration purpose only.

In FIG. 6, the first inductive element 21 is an inductor one end of which is connected to the output side of the carrier amplifier 6.

The second inductive element 22 is an inductor one end of which is connected to the other end of the first inductive element 21 and the other end of which is connected to one of the input sides of the signal synthesizer 9.

The variable capacitance element 23 is a variable capacitor one end of which is connected to the other end of the first inductive element 21 and the other end of which is grounded.

Next, the operation will be described.

A signal distributor 2 adjusts the phase shift amount in the phase shifter 7 depending on a frequency f of a digital signal D so that the phase delays by 90° by the phase shifter 7.

Hereinafter, a method for adjusting the phase shift amount by the phase shifter 7 will be specifically described.

The signal distributor 2 stores a table indicating the relationship between the frequency f of the digital signal D and a capacitance value C of the variable capacitance element 23 in the phase shifter 7.

The signal distributor 2 refers to the table to obtain the capacitance value C corresponding to the frequency f of the digital signal D.

The signal distributor 2 adjusts the variable capacitance element 23 so that the capacitance value of the variable capacitance element 23 becomes the acquired value C.

For example, the signal distributor 2 adjusts the variable capacitance element 23 so that the capacitance value C of the variable capacitance element 23 becomes smaller than a reference capacitance value C₀ if the frequency f of the digital signal D is higher than a reference frequency f₀.

The signal distributor 2 adjusts the variable capacitance element 23 so that the capacitance value C of the variable capacitance element 23 becomes larger than the reference capacitance value C₀ if the frequency f of the digital signal D is lower than a reference frequency f₀.

The signal distributor 2 does not adjust the variable capacitance element 23 in a case where the frequency f of the digital signal D matches the reference frequency fo.

As a result, even if the frequency f of the digital signal D changes, it is possible to set the phase shift amount of the signal by the phase shifter 7 to 90°. Therefore, if the phase of the first digital signal D₁ is set to θ₁ = 0°, the phase of the output signal of the phase shifter 7 becomes -90°.

Also in a case where the phase shifter 7 includes the first inductive element 21, the second inductive element 22, and the variable capacitance element 23, the phase shift amount of a signal can be adjusted depending on the frequency f of the digital signal D like in the first embodiment.

### Third Embodiment

In the first embodiment, an example in which the phase shifter 7 includes the inductive element 11, the first variable capacitance element 12, and the second variable capacitance element 13 is illustrated.

In a second embodiment, an example in which a phase shifter 7 includes a transmission line 31, a first variable capacitance element 32, and a second variable capacitance element 33 will be described.

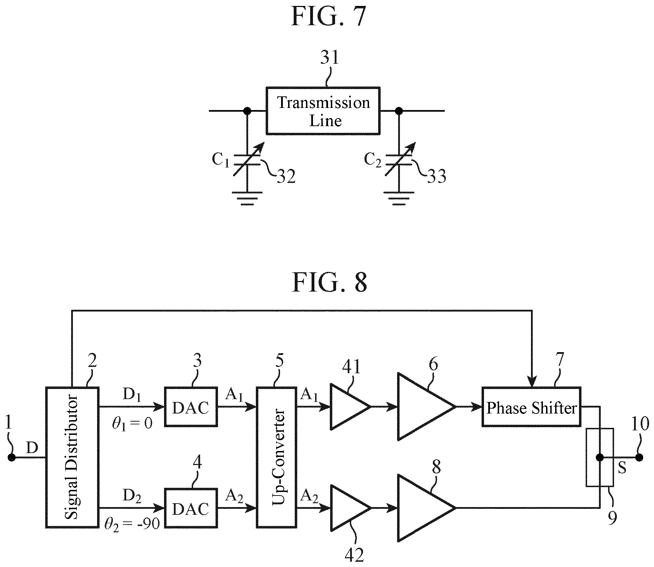

FIG. 7 is a configuration diagram illustrating the phase shifter 7 of a Doherty amplifier according to a third embodiment of the present invention.

In FIG. 7, the transmission line 31 is a line one end of which is connected to an output side of a carrier amplifier 6 and the other end of which is connected to one of the input sides of a signal synthesizer 9.

The first variable capacitance element 32 is a variable capacitor one end of which is connected to the output side of the carrier amplifier 6 and the other end of which is grounded.

The second variable capacitance element 33 is a variable capacitor one end of which is connected to one of the input sides of the signal synthesizer 9 and the other end of which is grounded.

Next, the operation will be described.

The signal distributor 2 adjusts the phase shift amount in the phase shifter 7 depending on a frequency f of a digital signal D so that the phase delays by 90° by the phase shifter 7.

Hereinafter, a method for adjusting the phase shift amount by the phase shifter 7 will be specifically described.

The signal distributor 2 stores a table indicating the relationship between a frequency f of a digital signal D, a capacitance value C₁ of the first variable capacitance element 32 in the phase shifter 7 and a capacitance value C2 of the second variable capacitance element 33 in the phase shifter 7.

The signal distributor 2 refers to the table to obtain the capacitance value C₁ and the capacitance value C2 each corresponding to the frequency f of the digital signal D.

The signal distributor 2 adjusts the first variable capacitance element 32 so that the capacitance value of the first variable capacitance element 32 becomes the acquired value C₁.

Further, the signal distributor 2 adjusts the second variable capacitance element 33 so that the capacitance value of the second variable capacitance element 33 becomes the acquired value C2.

For example, the signal distributor 2 adjusts the first variable capacitance element 32 so that the capacitance value C₁ of the first variable capacitance element 32 becomes smaller than a reference capacitance value C_{1,0} if the frequency f of the digital signal D is higher than a reference frequency fo. Further, the signal distributor 2 adjusts the second variable capacitance element 33 so that the capacitance value C2 of the second variable capacitance element 33 becomes smaller than a reference capacitance value C_{2,0}.

The signal distributor 2 adjusts the first variable capacitance element 32 so that the capacitance value C₁ of the first variable capacitance element 32 becomes larger than the reference capacitance value C _{1,0} if the frequency f of the digital signal D is lower than the reference frequency fo. Further, the signal distributor 2 adjusts the second variable capacitance element 33 so that the capacitance value C2 of the second variable capacitance element 33 becomes larger than the reference capacitance value C_{2,0}.

The signal distributor 2 does not adjust the first variable capacitance element 32 nor the second variable capacitance element 33 if the frequency f of the digital signal D matches the reference frequency f₀.

As a result, even if the frequency f of the digital signal D changes, it is possible to set the phase shift amount of the signal by the phase shifter 7 to 90°. Therefore, if the phase of the first digital signal D₁ is set to θ₁ = 0°, the phase of the output signal of the phase shifter 7 becomes -90°.

Also in a case where the phase shifter 7 includes the transmission line 31, the first variable capacitance element 32, and the second variable capacitance element 33, the phase shift amount of a signal can be adjusted depending on the frequency f of the digital signal D like in the first embodiment.

### Fourth Embodiment

In the first embodiment, the Doherty amplifier including the carrier amplifier 6 and the peak amplifier 8 is illustrated.

In a fourth embodiment, an example in which a first drive amplifier 41 is connected to a carrier amplifier 6 in series and a second drive amplifier 42 is connected to a peak amplifier 8 in series will be described.

FIG. 8 is a configuration diagram illustrating a Doherty amplifier according to the fourth embodiment of the invention. In FIG. 8, the same symbols as those in FIG. 1 represent the same or corresponding parts and thus descriptions thereof are omitted.

The first drive amplifier 41 amplifies a first analog signal A₁ output from an up-converter 5 and outputs the amplified first analog signal A₁ to the carrier amplifier 6.

The second drive amplifier 42 amplifies a second analog signal A₂ output from the up-converter 5 and outputs the amplified second analog signal A₂ to the peak amplifier 8.

The configuration of this embodiment is the same as the configuration of the first embodiment except that the first drive amplifier 41 is provided to the preceding stage of the carrier amplifier 6 and the second drive amplifier 42 is provided to the preceding stage of the peak amplifier 8.

By amplifying the first analog signal A₁ by the first drive amplifier 41, and by amplifying the second analog signal A₂ by the second drive amplifier 42, the output power of the Doherty amplifier can be enhanced more than that of the first embodiment.

### Fifth Embodiment

In a fifth embodiment, an amplification circuit in which multiple Doherty amplifiers are connected in parallel will be described.

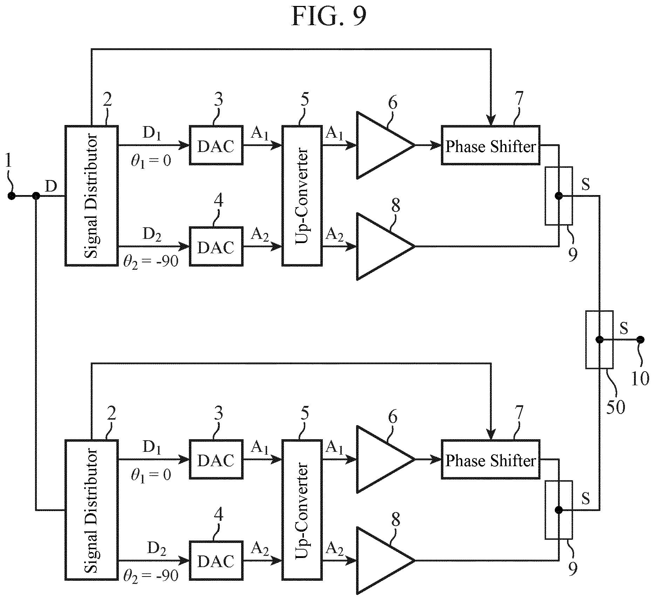

FIG. 9 is a configuration diagram illustrating an amplification circuit according to the fifth embodiment of the present invention. In FIG. 9, the same symbols as those in FIG. 1 represent the same or corresponding parts and thus descriptions thereof are omitted.

A signal synthesizer 50 combines synthesized signals S output from two signal synthesizers 9, and outputs a synthesized signal of the two synthesized signals S to an output terminal 10.

In FIG. 9, the amplification circuit in which two Doherty amplifiers are connected in parallel is illustrated. Further, three or more Doherty amplifiers may be connected in parallel in an amplification circuit.

Even in a case where multiple Doherty amplifiers are connected in parallel, it is possible to suppress unnecessary power consumption at the time of back-off operation and to suppress deterioration of power efficiency like in the first embodiment even when a frequency of a signal to be amplified changes.

### INDUSTRIAL APPLICABILITY

The present invention is suitable for a Doherty amplifier and an amplification circuit for amplifying a signal to be amplified.

### REFERENCE SIGNS LIST

1: Input terminal, 2: Signal distributor, 3, 4: Digital/analog converter, 5: Up-converter, 6: Carrier amplifier, 7: Phase shifter, 8: Peak amplifier, 9: Signal synthesizer, 10: Output terminal, 11: Inductive element, 12: First variable capacitance element, 13: Second variable capacitance element, 21: First inductive element, 22: Second inductive element, 23: Variable capacitance element, 31: Transmission line, 32: First variable capacitance element, 33: Second variable capacitance element, 41: First drive amplifier, 42: Second drive amplifier, 50: Signal synthesizer.

## Claims

1. A Doherty amplifier comprising:
a signal distributor (2) configured to divide a signal (D) to be amplified to signals (D₁, A₁, D₂, A₂) and distributing the signals and configured to store a table indicating the relationship between a frequency of the signal (D) to be amplified, a capacitance value (C₁) of a first variable capacitance element (12) and a capacitance value (C₂) of a second variable capacitance element (13);
an up-converter (5) configured to perform frequency conversion on the signals distributed by the signal distributor (2) to increase the frequency of the distributed signals,
a carrier amplifier (6) configured to amplify one of the signals (A₁) distributed by the signal distributor and frequency converted by the up-converter (5);
a phase shifter (7) configured to adjust a phase of the one of the signals (A₁) amplified by the carrier amplifier, comprising the first variable capacitance element (12) and the second variable capacitance element (13);
a peak amplifier (8) configured to amplify another one of the signals (A₂) distributed by the signal distributor and frequency converted by the up-converter (5); and
a signal synthesizer (9) configured to synthesize the one of the signals (A₁), the phase of which is adjusted by the phase shifter, and said another one of the signals (A₂) amplified by the peak amplifier,
wherein the signal distributor is configured to compare a power of the signal (D) to be amplified with a threshold value set in advance, and, in a case where the power of the signal (D) to be amplified is greater than or equal to a threshold value, the threshold value being set in advance to a power at which the carrier amplifier is in its saturation region, the signal distributor is configured to output the one of the signals (D₁) to the carrier amplifier, to output said another one of the signals (D₂), a phase of which is 90 degrees behind the phase of the one of the signals, to the peak amplifier, and to adjust a phase shift amount of a signal shifted by the phase shifter depending on the frequency of the signal to be amplified so that the phase delays by 90° by the phase shifter, and,
in a case where the power of the signal (D) to be amplified is less than the threshold value, the signal distributor is configured to output the one of the signals (D₁) to the carrier amplifier without outputting said another one of the signals (D₂) to the peak amplifier, wherein the phase shifter consists in: an inductive element (11) which is an inductor, one end of which is connected to an output side of the carrier amplifier and another end of which is connected to one of input sides of the signal synthesizer;
the first variable capacitance element (12) which is a variable capacitor, one end of which is connected to the output side of the carrier amplifier and another end of which is grounded, having a capacitance value (C₁) adjusted by the signal distributor (2); and
the second variable capacitance element (13) which is a variable capacitor, one end of which is connected to the one of the input sides of the signal synthesizer and another end of which is grounded, having a capacitance value (C₂) adjusted by the signal distributor (2);
where in the case where the power of the signal (D) to be amplified is greater than or equal to a threshold value,
if the frequency of the signal (D) to be amplified is higher than a reference frequency, the signal distributor (2) is configured to adjust the first variable capacitance element (12) so that the capacitance value (C₁) of the first variable capacitance element (12) becomes smaller than a first reference capacitance value, and the second variable capacitance element (13) so that the capacitance value (C₂) of the second variable capacitance element (13) becomes smaller than a second reference capacitance value; and
if the frequency of the signal (D) to be amplified is lower than a reference frequency, the signal distributor (2) is configured to adjust the first variable capacitance element (12) so that the capacitance value (C₁) of the first variable capacitance element (12) becomes larger than the first reference capacitance value, and the second variable capacitance element (13) so that the capacitance value (C₂) of the second variable capacitance element (13) becomes larger than the second reference capacitance value; and
if the frequency of the signal (D) to be amplified matches the reference frequency, the signal distributor (2) is configured to not adjust the first variable capacitance element (12) nor the second variable capacitance element (13).

2. A Doherty amplifier comprising:
a signal distributor (2) configured to divide a signal (D) to be amplified to signals (D₁, A₁, D₂, A₂) and distributing the signals and configured to store a table indicating the relationship between a frequency of the signal (D) to be amplified, a capacitance value (C₁) of a first variable capacitance element (32) and a capacitance value (C₂) of a second variable capacitance element (33);
an up-converter (5) configured to perform frequency conversion on the signals distributed by the signal distributor(2) to increase the frequency of the distributed signals,
a carrier amplifier (6) configured to amplify one of the signals (A₁) distributed by the signal distributor and frequency converted by the up-converter (5); and
a phase shifter (7) configured to adjust a phase of the one of the signals (A₁) amplified by the carrier amplifier, comprising the first variable capacitance element (12) and the second variable capacitance element (13);
a peak amplifier (8) configured to amplify another one of the signals (A₂) distributed by the signal distributor and frequency converted by the up-converter (5); and
a signal synthesizer (9) configured to synthesize the one of the signals (A₁), the phase of which is adjusted by the phase shifter, and said another one of the signals (A₂) amplified by the peak amplifier,
wherein the signal distributor is configured to compare a power of the signal (D) to be amplified with a threshold value set in advance, and, in a case where the power of the signal (D) to be amplified is greater than or equal to a threshold value, the threshold value being set in advance to a power at which the carrier amplifier is in its saturation region, the signal distributor is configured to output the one of the signals (D₁) to the carrier amplifier, to output said another one of the signals (D₂), a phase of which is 90 degrees behind the phase of the one of the signals, to the peak amplifier, and to adjust a phase shift amount of a signal shifted by the phase shifter depending on the frequency of the signal to be amplified so that the phase delays by 90° by the phase shifter, and,
in a case where the power of the signal (D) to be amplified is less than the threshold value, the signal distributor is configured to output the one of the signals (D₁) to the carrier amplifier without outputting said another one of the signals (D₂) to the peak amplifier, wherein the phase shifter 2. consists in:
a transmission line (31), one end of which is connected to an output side of the carrier amplifier and another end of which is connected to one of input sides of the signal synthesizer;
the first variable capacitance element (32) which is a variable capacitor, one end of which is connected to the output side of the carrier amplifier and another end of which is grounded, having a capacitance value (C₁) adjusted by the signal distributor (2); and
the second variable capacitance element (33) which is a variable capacitor, one end of which is connected to the one of the input sides of the signal synthesizer and another end of which is grounded, having a capacitance value (C₂) adjusted by the signal distributor (2);
where in the case where the power of the signal to be amplified is greater than or equal to a threshold value,
if the frequency of the signal to be amplified is higher than yet another reference frequency, the signal distributor (2) is configured to adjust the first variable capacitance element (32) so that the capacitance value (C₁) of the first variable capacitance element (32) becomes smaller than another first reference capacitance value, and the second variable capacitance element (33) so that the capacitance value (C₂) of the second variable capacitance element (33) becomes smaller than another second reference capacitance value;
if the frequency of the signal to be amplified is lower than the yet another reference frequency, the signal distributor (2) is configured to adjust the first variable capacitance element (32) so that the capacitance value (C₁) of the first variable capacitance element (32) becomes larger than the another first reference capacitance value, and the second variable capacitance element (33) so that the capacitance value (C₂) of the second variable capacitance element (33) becomes larger than the another second reference capacitance value; and
if the frequency of the signal to be amplified matches the yet another reference frequency, the signal distributor (2) is configured to not adjust the first variable capacitance element (32) nor the second variable capacitance element (33).

3. The Doherty amplifier according to claim 1 or 2, further comprising:
a first drive amplifier (41) configured to amplify one of the signals distributed by the signal distributor and outputting the amplified signal to the carrier amplifier; and
a second drive amplifier (42) configured to amplify another one of the signals distributed by the signal distributor and outputting the amplified signal to the peak amplifier.

4. An amplification circuit including a plurality of Doherty amplifiers according to any of the preceding claims, connected to each other in parallel.

## Patentansprüche

1. Doherty-Verstärker, umfassend:
einen Signalverteiler (2), der eingerichtet ist, ein zu verstärkendes Signal (D) in Signale (D₁, A₁, D₂, A₂) aufzuteilen und die Signale zu verteilen, und eingerichtet ist, eine Tabelle, angebend die Beziehung zwischen einer Frequenz des zu verstärkenden Signals (D), einem Kapazitätswert (C₁) eines ersten variablen Kapazitätselements (12) und einem Kapazitätswert (C₂) eines zweiten variablen Kapazitätselements (13), zu speichern;
einen Aufwärtswandler (5), der eingerichtet ist, Frequenzumwandlung auf die durch den Signalverteiler (2) verteilten Signale durchzuführen, um die Frequenz der verteilten Signale zu erhöhen,
einen Trägerverstärker (6), der eingerichtet ist, eines von den Signalen (A₁), die durch den Signalverteiler verteilt sind, und einer Frequenz, die durch den Aufwärtswandler (5) umgewandelt ist, zu verstärken;
einen Phasenschieber (7), der eingerichtet ist, eine Phase des einen der Signale (A₁), das durch den Trägerverstärker verstärkt ist, umfassend das erste variable Kapazitätselement (12) und das zweite variable Kapazitätselement (13), anzupassen;
einen Spitzenverstärker (8), der eingerichtet ist, ein anderes der Signale (A₂), das durch den Signalverteiler verteilt ist und durch den Aufwärtswandler (5) frequenzgewandelt ist, zu verstärken; und
einen Signal-Synthetisierer (9), der eingerichtet ist, das eine der Signale (A₁), dessen Phase durch den Phasenschieber angepasst ist, und das andere der Signale (A₂), das durch den Spitzenverstärker verstärkt ist, zu synthetisieren,
wobei der Signalverteiler eingerichtet ist, eine Leistung des zu verstärkenden Signals (D) mit einem im Voraus festgelegten Schwellenwert zu vergleichen, und in einem Fall, in dem die Leistung des zu verstärkenden Signals (D) größer ist als oder gleich ist wie ein Schwellenwert, wobei der Schwellenwert im Voraus auf eine Leistung festgelegt wird, bei der sich der Trägerverstärker in seinem Sättigungsbereich befindet, der Signalverteiler eingerichtet ist, das eine der Signale (D₁) an den Trägerverstärker auszugeben, um das andere der Signale (D₂), dessen Phase um 90 Grad hinter der Phase des einen der Signale liegt, an den Spitzenverstärker auszugeben, und einen Phasenverschiebungsbetrag eines durch den Phasenschieber verschobenen Signals in Abhängigkeit von der Frequenz des zu verstärkenden Signals anzupassen, so dass die Phase durch den Phasenschieber um 90° verzögert ist, und,
in einem Fall, in dem die Leistung des zu verstärkenden Signals (D) kleiner ist als der Schwellenwert, der Signalverteiler eingerichtet ist, das eine der Signale (D₁) an den Trägerverstärker auszugeben, ohne das andere der Signale (D₂) an den Spitzenverstärker auszugeben, wobei der Phasenschieber gebildet ist aus: einem induktiven Element (11), das ein Induktor ist, dessen eines Ende mit einer Ausgangsseite des Trägerverstärkers verbunden ist und dessen anderes Ende mit einer von Eingangsseiten des Signal-Synthetisierers verbunden ist;
dem ersten variablen Kapazitätselement (12), das ein variabler Kondensator ist, dessen eines Ende mit der Ausgangsseite des Trägerverstärkers verbunden ist und dessen anderes Ende geerdet ist, das einen Kapazitätswert (C₁) aufweist, der durch den Signalverteiler (2) angepasst ist; und
dem zweiten variablen Kapazitätselement (13), das ein variabler Kondensator ist, dessen eines Ende mit der einen der Eingangsseiten des Signal-Synthetisierers verbunden ist und dessen anderes Ende geerdet ist, das einen Kapazitätswert (C2) aufweist, der durch den Signalverteiler (2) angepasst ist;
wobei in dem Fall, in dem die Leistung des zu verstärkenden Signals (D) größer ist als oder gleich ist wie ein Schwellenwert,
falls die Frequenz des zu verstärkenden Signals (D) höher ist als eine Referenzfrequenz, der Signalverteiler (2) eingerichtet ist, das erste variable Kapazitätselement (12) anzupassen, so dass der Kapazitätswert (C₁) des ersten variablen Kapazitätselements (12) kleiner wird als ein erster Referenzkapazitätswert, und das zweite variable Kapazitätselement (13) anzupassen, so dass der Kapazitätswert (C₂) des zweiten variablen Kapazitätselements (13) kleiner wird als ein zweiter Referenzkapazitätswert; und
falls die Frequenz des zu verstärkenden Signals (D) niedriger ist als eine Referenzfrequenz, der Signalverteiler (2) eingerichtet ist, das erste variable Kapazitätselement (12) anzupassen, so dass der Kapazitätswert (C₁) des ersten variablen Kapazitätselements (12) größer wird als der erste Referenzkapazitätswert, und das zweite variable Kapazitätselement (13) anzupassen, so dass der Kapazitätswert (C₂) des zweiten variablen Kapazitätselements (13) größer wird als der zweite Referenzkapazitätswert; und
falls die Frequenz des zu verstärkenden Signals (D) mit der Referenzfrequenz übereinstimmt, der Signalverteiler (2) eingerichtet ist, weder das erste variable Kapazitätselement (12) noch das zweite variable Kapazitätselement (13) anzupassen.

2. Doherty-Verstärker, umfassend:
einen Signalverteiler (2), der eingerichtet ist, ein zu verstärkendes Signal (D) in Signale (D₁, A₁, D₂, A₂) aufzuteilen und die Signale zu verteilen, und eingerichtet ist, eine Tabelle, angebend die Beziehung zwischen einer Frequenz des zu verstärkenden Signals (D), einem Kapazitätswert (C₁) eines ersten variablen Kapazitätselements (32) und einem Kapazitätswert (C₂) eines zweiten variablen Kapazitätselements (33), zu speichern;
einen Aufwärtswandler (5), der eingerichtet ist, Frequenzumwandlung auf die durch den Signalverteiler (2) verteilten Signale durchzuführen, um die Frequenz der verteilten Signale zu erhöhen,
einen Trägerverstärker (6), der eingerichtet ist, eines der durch den Signalverteiler verteilten und durch den Aufwärtswandler (5) frequenzgewandelten Signale (A₁) zu verstärken; und
einen Phasenschieber (7), der eingerichtet ist, eine Phase des einen der Signale (A₁), das durch den Trägerverstärker verstärkt ist, umfassend das erste variable Kapazitätselement (12) und das zweite variable Kapazitätselement (13), anzupassen;
einen Spitzenverstärker (8), der eingerichtet ist, ein anderes der Signale (A₂), das durch den Signalverteiler verteilt ist und durch den Aufwärtswandler (5) frequenzgewandelt ist, zu verstärken; und
einen Signal-Synthetisierer (9), der eingerichtet ist, das eine der Signale (A₁), dessen Phase durch den Phasenschieber angepasst ist, und das andere der Signale (A₂), das durch den Spitzenverstärker verstärkt ist, zu synthetisieren,
wobei der Signalverteiler eingerichtet ist, eine Leistung des zu verstärkenden Signals (D) mit einem im Voraus festgelegten Schwellenwert zu vergleichen, und in einem Fall, in dem die Leistung des zu verstärkenden Signals (D) größer ist als oder gleich ist wie ein Schwellenwert, wobei der Schwellenwert im Voraus auf eine Leistung festgelegt ist, bei der sich der Trägerverstärker in seinem Sättigungsbereich befindet, der Signalverteiler eingerichtet ist, das eine der Signale (D₁) an den Trägerverstärker auszugeben, um das andere der Signale (D₂), dessen Phase um 90 Grad hinter der Phase des einen der Signale liegt, an den Spitzenverstärker auszugeben, und einen Phasenverschiebungsbetrag eines durch den Phasenschieber verschobenen Signals in Abhängigkeit von der Frequenz des zu verstärkenden Signals anzupassen, so dass die Phase durch den Phasenschieber um 90° verzögert ist, und,
in einem Fall, in dem die Leistung des zu verstärkenden Signals (D) kleiner ist als der Schwellenwert, der Signalverteiler eingerichtet ist, das eine der Signale (D₁) an den Trägerverstärker auszugeben, ohne das andere der Signale (D₂) an den Spitzenverstärker auszugeben, wobei der Phasenschieber gebildet ist aus:
einer Übertragungsleitung (31), deren eines Ende mit einer Ausgangsseite des Trägerverstärkers verbunden ist und deren anderes Ende mit einer der Eingangsseiten des Signal-Synthetisierers verbunden ist;
dem ersten variablen Kapazitätselement (32), das ein variabler Kondensator ist, dessen eines Ende mit der Ausgangsseite des Trägerverstärkers verbunden ist und dessen anderes Ende geerdet ist, das einen Kapazitätswert (C₁) aufweist, der durch den Signalverteiler (2) angepasst ist; und
dem zweiten variablen Kapazitätselement (33), das ein variabler Kondensator ist, dessen eines Ende mit der einen der Eingangsseiten des Signal-Synthetisierers verbunden ist und dessen anderes Ende geerdet ist, aufweisend einen Kapazitätswert (C₂), der durch den Signalverteiler (2) angepasst ist;
wobei in dem Fall, in dem die Leistung des zu verstärkenden Signals größer ist als oder gleich ist wie ein Schwellenwert,
falls die Frequenz des zu verstärkenden Signals höher ist als eine weitere Referenzfrequenz, der Signalverteiler (2) eingerichtet ist, das erste variable Kapazitätselement (32) anzupassen, so dass der Kapazitätswert (C₁) des ersten variablen Kapazitätselements (32) kleiner wird als ein weiterer erster Referenzkapazitätswert, und das zweite variable Kapazitätselement (33) anzupassen, so dass der Kapazitätswert (C₂) des zweiten variablen Kapazitätselements (33) kleiner wird als ein weiterer zweiter Referenzkapazitätswert;
falls die Frequenz des zu verstärkenden Signals geringer ist als die weitere Referenzfrequenz, der Signalverteiler (2) eingerichtet ist, das erste variable Kapazitätselement (32) anzupassen, so dass der Kapazitätswert (C₁) des ersten variablen Kapazitätselements (32) größer wird als der weitere erste Referenzkapazitätswert, und das zweite variable Kapazitätselement (33) anzupassen, so dass der Kapazitätswert (C₂) des zweiten variablen Kapazitätselements (33) größer wird als der weitere zweite Referenzkapazitätswert; und
falls die Frequenz des zu verstärkenden Signals mit einer weiteren Referenzfrequenz übereinstimmt, der Signalverteiler (2) eingerichtet ist, weder das erste variable Kapazitätselement (32) noch das zweite variable Kapazitätselement (33) anzupassen.

3. Doherty-Verstärker nach Anspruch 1 oder 2, ferner umfassend:
einen ersten Treiberverstärker (41), der eingerichtet ist, eines der durch den Signalverteiler verteilten Signale zu verstärken und das verstärkte Signal an den Trägerverstärker auszugeben; und
einen zweiten Treiberverstärker (42), der eingerichtet ist, ein weiteres der durch den Signalverteiler verteilten Signale zu verstärken und das verstärkte Signal an den Spitzenwertverstärker auszugeben.

4. Verstärkerschaltung, aufweisend eine Vielzahl von Doherty-Verstärkern nach einem der vorangehenden Ansprüche, die parallel zueinander verbunden sind.

## Revendications

1. Amplificateur Doherty comprenant :
un répartiteur de signal (2) configuré pour diviser un signal (D) à amplifier en signaux (D₁, A₁, D₂, A₂), et pour répartir les signaux, et configuré pour stocker une table qui indique les relations entre la fréquence du signal (D) à amplifier, une valeur de capacité (C₁) d'un premier élément à capacité variable (12), et une valeur de capacité (C₂) d'un second élément à capacité variable (13) ;
un convertisseur élévateur de fréquence (5) configuré pour exécuter une conversion de fréquence sur les signaux répartis par le répartiteur de signal (2), afin d'accroître la fréquence des signaux répartis,
un amplificateur de porteuse (6) configuré pour amplifier l'un des signaux (A₁) répartis par le répartiteur de signal, et la fréquence convertie par le convertisseur élévateur de fréquence (5) ;
un déphaseur (7) configuré pour régler la phase de l'un des signaux (A₁) amplifié par l'amplificateur de porteuse, comprenant le premier élément à capacité variable (12) et le second élément à capacité variable (13) ;
un amplificateur de crête (8) configuré pour amplifier un autre des signaux (A₂) répartis par le répartiteur de signal, et la fréquence convertie par le convertisseur élévateur de fréquence (5) ; et
un synthétiseur de signal (9) configuré pour synthétiser l'un des signaux (A₁), dont la phase est réglée par le déphaseur, et ledit autre des signaux (A₂) amplifié par l'amplificateur de crête,
dans lequel le distributeur de signal est configuré pour comparer la puissance du signal (D) à amplifier, à une valeur de seuil réglée à l'avance, et, dans le cas où la puissance du signal (D) à amplifier, est supérieure ou égale à une valeur de seuil, la valeur de seuil étant réglée à l'avance à une puissance pour laquelle l'amplificateur de porteuse se trouve dans sa région de saturation, le répartiteur de signal est configuré pour délivrer en sortie l'un des signaux (D₁) à l'amplificateur de porteuse, pour délivrer en sortie ledit autre des signaux (D₂), dont la phase est en arrière de 90 degrés de la phase de l'un des signaux, à l'amplificateur de crête, et pour régler la quantité de déphasage d'un signal déphasé par le déphaseur selon la fréquence du signal à amplifier, de telle sorte que la phase soit retardée de 90° par le déphaseur, et,
dans le cas où la puissance du signal (D) à amplifier est inférieure à la valeur de seuil, le répartiteur de signal est configuré pour délivrer en sortie l'un des signaux (D₁) à l'amplificateur de porteuse, sans délivrer en sortie ledit autre des signaux (D₂) à l'amplificateur de crête, dans lequel le déphaseur consiste en : un élément inductif (11) qui est un inducteur, dont une extrémité est connectée à un côté sortie de l'amplificateur de porteuse, et dont une autre extrémité est connectée à l'un des côtés entrée du synthétiseur de signal ;
le premier élément à capacité variable (12) qui est un condensateur variable, dont une extrémité est connectée au côté sortie de l'amplificateur de porteuse, et dont une autre extrémité est mise à la masse, qui présente une valeur de capacité (C₁) réglée par le répartiteur de signal (2) ; et
le second élément à capacité variable (13) qui est un condensateur variable, dont une extrémité est connectée à l'un des côtés entrée du synthétiseur de signal, et dont une autre extrémité est mise à la masse, qui présente une valeur de capacité (C₂) réglée par le répartiteur de signal (2) ;
dans lequel, dans le cas où la puissance du signal (D) à amplifier, est supérieure ou égale à une valeur de seuil,
si la fréquence du signal (D) à amplifier, est supérieure à une fréquence de référence, le répartiteur de signal (2) est configuré pour régler le premier élément à capacité variable (12) de telle sorte que la valeur de capacité (C₁) du premier élément à capacité variable (12) devienne inférieure à une première valeur de capacité de référence, et le second élément à capacité variable (13) de telle sorte que la valeur de capacité (C₂) du second élément à capacité variable (13) devienne inférieure à une seconde valeur de capacité de référence ; et
si la fréquence du signal (D) à amplifier, est inférieure à une fréquence de référence, le répartiteur de signal (2) est configuré pour régler le premier élément à capacité variable (12) de telle sorte que la valeur de capacité (C₁) du premier élément à capacité variable (12) devienne supérieure à la première valeur de capacité de référence, et le second élément à capacité variable (13) de telle sorte que la valeur de capacité (C₂) du second élément à capacité variable (13) devienne supérieure à la seconde valeur de capacité de référence ; et
si la fréquence du signal (D) à amplifier correspond à la fréquence de référence, le répartiteur de signal (2) est configuré pour ne régler ni le premier élément à capacité variable (12), ni le second élément à capacité variable (13).

2. Amplificateur Doherty comprenant :
un répartiteur de signal (2) configuré pour diviser un signal (D) à amplifier en signaux (D₁, A₁, D₂, A₂), et pour répartir les signaux, et configuré pour stocker une table qui indique les relations entre la fréquence du signal (D) à amplifier, une valeur de capacité (C₁) d'un premier élément à capacité variable (32), et une valeur de capacité (C₂) d'un second élément à capacité variable (33) ;
un convertisseur élévateur de fréquence (5) configuré pour exécuter une conversion de fréquence sur les signaux répartis par le répartiteur de signal (2), afin d'accroître la fréquence des signaux répartis,
un amplificateur de porteuse (6) configuré pour amplifier l'un des signaux (A₁) répartis par le répartiteur de signal, et la fréquence convertie par le convertisseur élévateur de fréquence (5) ; et
un déphaseur (7) configuré pour régler la phase de l'un des signaux (A₁) amplifié par l'amplificateur de porteuse, comprenant le premier élément à capacité variable (12) et le second élément à capacité variable (13) ;
un amplificateur de crête (8) configuré pour amplifier un autre des signaux (A₂) répartis par le répartiteur de signal, et la fréquence convertie par le convertisseur élévateur de fréquence (5) ; et
un synthétiseur de signal (9) configuré pour synthétiser l'un des signaux (A₁), dont la phase est réglée par le déphaseur, et ledit autre des signaux (A₂) amplifié par l'amplificateur de crête,
dans lequel le distributeur de signal est configuré pour comparer la puissance du signal (D) à amplifier, à une valeur de seuil réglée à l'avance, et, dans le cas où la puissance du signal (D) à amplifier, est supérieure ou égale à une valeur de seuil, la valeur de seuil étant réglée à l'avance à une puissance pour laquelle l'amplificateur de porteuse se trouve dans sa région de saturation, le répartiteur de signal est configuré pour délivrer en sortie l'un des signaux (D₁) à l'amplificateur de porteuse, pour délivrer en sortie ledit autre des signaux (D₂), dont la phase est en arrière de 90 degrés de la phase de l'un des signaux, à l'amplificateur de crête, et pour régler la quantité de déphasage d'un signal déphasé par le déphaseur selon la fréquence du signal à amplifier, de telle sorte que la phase soit retardée de 90° par le déphaseur, et,
dans le cas où la puissance du signal (D) à amplifier est inférieure à la valeur de seuil, le répartiteur de signal est configuré pour délivrer en sortie l'un des signaux (D₁) à l'amplificateur de porteuse, sans délivrer en sortie ledit autre des signaux (D₂) à l'amplificateur de crête, dans lequel le déphaseur consiste en :
une ligne de transmission (31), dont une extrémité est connectée à un côté sortie de l'amplificateur de porteuse, et dont une autre extrémité est connectée à l'un des côtés entrée du synthétiseur de signal ;
le premier élément à capacité variable (32) qui est un condensateur variable, dont une extrémité est connectée au côté sortie de l'amplificateur de porteuse, et dont une autre extrémité est mise à la masse, qui présente une valeur de capacité (C₁) réglée par le répartiteur de signal (2) ; et
le second élément à capacité variable (33) qui est un condensateur variable, dont une extrémité est connectée à l'un des côtés entrée du synthétiseur de signal, et dont une autre extrémité est mise à la masse, qui présente une valeur de capacité (C₂) réglée par le répartiteur de signal (2) ;
dans lequel, dans le cas où la puissance du signal à amplifier, est supérieure ou égale à une valeur de seuil,
si la fréquence du signal à amplifier, est supérieure à encore une autre fréquence de référence, le répartiteur de signal (2) est configuré pour régler le premier élément à capacité variable (32) de telle sorte que la valeur de capacité (C₁) du premier élément à capacité variable (32) devienne inférieure à une autre première valeur de capacité de référence, et le second élément à capacité variable (33) de telle sorte que la valeur de capacité (C₂) du second élément à capacité variable (33) devienne inférieure à une autre seconde valeur de capacité de référence ;
si la fréquence du signal à amplifier, est inférieure à l'autre encore fréquence de référence, le répartiteur de signal (2) est configuré pour régler le premier élément à capacité variable (32) de telle sorte que la valeur de capacité (C₁) du premier élément à capacité variable (32) devienne supérieure à l'autre première valeur de capacité de référence, et le second élément à capacité variable (33) de telle sorte que la valeur de capacité (C₂) du second élément à capacité variable (33) devienne supérieure à l'autre seconde valeur de capacité de référence ; et
si la fréquence du signal à amplifier correspond à l'autre encore fréquence de référence, le répartiteur de signal (2) est configuré pour ne régler ni le premier élément à capacité variable (32), ni le second élément à capacité variable (33).

3. Amplificateur Doherty selon la revendication 1 ou 2, comprenant en outre :
un premier amplificateur de commande (41) configuré pour amplifier l'un des signaux répartis par le répartiteur de signal, et pour délivrer en sortie le signal amplifié à l'amplificateur de porteuse ; et
un second amplificateur de commande (42) configuré pour amplifier un autre des signaux répartis par le répartiteur de signal, et pour délivrer en sortie le signal amplifié à l'amplificateur de crête.

4. Circuit d'amplification comprenant une pluralité d'amplificateurs Doherty selon l'une quelconque des revendications précédentes, connectés les uns aux autres en parallèle.
